# EUROPÄISCHE PATENTSCHRIFT

(11) **EP 0 591 769 B1**
(45) Veröffentlichungstag und Bekanntmachung des Hinweises auf die Patenterteilung: **20.01.1999**
(21) Anmeldenummer: 93115286.2
(22) Anmeldetag: 22.09.1993
(51) Int. Cl.: H01L 21/768, H01L 23/48

(54) **Herstellverfahren für ein selbstjustiertes Kontaktloch und Halbleiterstruktur**
Process for manufacturing a self-adjusted contact and semiconductor structure
Procédé pour la fabrication d'un orifice de contact auto-ajusté et structure de semiconducteur

(30) Priorität: 29.09.1992 DE 4232621
(43) Veröffentlichungstag der Anmeldung: 13.04.1994
(73) Patentinhaber: SIEMENS AKTIENGESELLSCHAFT, 80333 München (DE)
(72) Erfinder: Melzner, Hanno, Dipl.-Phys., D-85655 Grosshelfendorf (DE)

(56) Entgegenhaltungen:
- US-A- 4 916 087
- PATENT ABSTRACTS OF JAPAN vol. 16, no. 196 (E-1200) 12. Mai 1992 & JP-A-04 029 318 (OKI ELECTRIC IND CO LTD) 31. Januar 1992
- PATENT ABSTRACTS OF JAPAN vol. 17, no. 150 (E-1339) 25. März 1993 & JP-A-04 315 454 (SONY CORP) 6. November 1992
- PATENT ABSTRACTS OF JAPAN vol. 17, no. 81 (E-1321) 18. Februar 1993 & JP-A-04 279 037 (TOSHIBA CORP) 5. Oktober 1992

## Beschreibung

Die Erfindung betrifft ein Herstellverfahren für ein selbstjustiertes Kontaktloch einer integrierten Halbleiterschaltung mit auf einem Halbleitersubstrat angeordneten bahnförmigen Strukturen, wobei das Kontaktloch ein zwischen zwei bahnförmigen Strukturen befindliches, tieferliegendes leitendes Gebiet mindestens teilweise freilegt, sowie eine Halbleiterstruktur mit bahnförmigen Strukturen auf einem Halbleitersubstrat und einem zwischen den bahnförmigen Strukturen angeordneten tieferliegenden Gebiet.

Bei der Herstellung von integrierten Schaltungen ist es häufig notwendig, Kontakte zwischen verschiedenen leitenden Strukturen, beispielsweise einer oberen Leitbahn zu einem tieferliegenden leitenden Gebiet, herzustellen. Aufgrund der zunehmenden Verkleinerung der lateralen Ausmaße aller Strukturen auf dem Halbleitersubstrat werden solche Kontakte bevorzugt selbstjustiert hergestellt, d. h. die tatsächliche Kontaktfläche wird nicht lithografisch, sondern durch schon vorhandene Strukturen definiert. In vielen Fällen kann aber auch bei der Herstellung eines selbstjustierten Kontaktlochs nicht völlig auf eine Fotolackmaske mit entsprechend aufwendiger Prozeßführung verzichtet werden, nur ist die Justierung dieser Fotolackmaske relativ unkritisch.

Ein Beispiel dafür ist die Herstellung eines selbstjustierten Kontaktes zwischen einer Bitleitung und einem tieferliegenden S/D-Gebiet eines Transistors in einer DRAM-Schaltung. Das Kontaktloch ist dabei zwischen den mit einer Oxideinkapselung versehenen Wortleitung angeordnet.

Wie in dem Artikel von Küsters et al., Symposion in VLSI Technology 1987, Japan, Seite 93 - 94 beschrieben, kann ein selbstjustiertes Kontaktloch dadurch hergestellt werden, daß nach der Oxideinkapselung eine Oxid/Nitrid/ Oxid-Dreifach-Schicht ganzflächig aufgebracht und unter Einsatz einer Fototechnik in mehreren Ätzprozessen, wobei die Nitridschicht als Ätzstop dient, über dem leitenden Gebiet wieder entfernt wird. Das Kontaktloch in der Fotomaske ist dabei größer als die tatsächliche Kontaktfläche, die im wesentlichen durch die Oxideinkapselung definiert wird.

US-A-4 916 087 offenbart ein Verfahren zum Ausfüllen von Gräben, bei dem der Boden der Gräben durch ein selbstjustiertes Ätzverfahren freigelegt wird.

Ein Nachteil dieses sogenannten FOBIC-Prozesses ist, daß die notwendige Nitridschicht mechanische Spannungen hervorruft, die in der Nähe der Wortleitungen Versetzungen verursachen können. Ferner können Probleme bei der Strukturierung der Bitleitung in Relation zur Ätzkante der oberen Oxidschicht entstehen: Liegt die Bitleitungskante in etwa über dieser Ätzkante, können hochstehende Filamente des Bitleitungsmaterials entstehen, die zu Kurzschlüssen führen können. Wird dagegen die Ätzkante nicht von der Bitleitung überlappt, erhält man eine ungünstige Topographie. Ein weiterer Nachteil ist, daß die obere Oxidschicht aufgrund des Naßätzprozesses nur mäßig dotiert werden kann, wodurch eine Planarisierung in einem späteren Verfließschritt eingeschränkt ist.

Aufgabe der Erfindung ist es, eine weitere Realisierungsmöglichkeit für ein selbstjustiertes Kontaktloch anzugeben.

Diese Aufgabe wird durch die Merkmale der Patentansprüche 1 und 6 gelöst. Vorteilhafte Weiterbildungen sind Gegenstand von Unteransprüchen.

Die Erfindung beruht auf einem speziellen Design der das Kontaktloch definierenden Strukturen, also z. B. der Wortleitungen (Gateebene) beim oben erläuterten Beispiel des Bitleitungs-Kontaktlochs. In der Nähe des zu kontaktierenden leitenden Gebietes ist der Abstand zwischen den Strukturen vergrößert gegenüber den Bereichen, in denen kein Kontaktloch gebildet werden soll. Durch Anpassung der Schichtdicke einer auf den Strukturen und dem Halbleitersubstrat abzuscheidenden Zwischenschicht an diese Abstände und durch den Einsatz eines anisotropen Ätzprozesses für die Zwischenschicht können selbstjustierte Kontaktlöcher sogar völlig ohne Fototechnik erzeugt werden. Die schmalen Abstände bleiben dabei vollständig mit der isolierenden Zwischenschicht aufgefüllt, während in den vergrößerten Zwischenräumen Spacer an den Seitenwänden der bahnförmigen Strukturen gebildet werden, die das selbstjustierte Kontaktloch umschließen.

Die Vorteile des Verfahrens liegen unter anderem in den gut verrundeten Flanken der Kontaktlöcher und der hochgradigen Planarisierung der Oberfläche nach dem Verfahren. Gegenüber dem bekannten FOBIC-Verfahren ist die Anzahl der Prozeßschritte verringert, und die Nitridschicht entfällt.

Die Erfindung wird im folgenden anhand eines in den Figuren dargestellten Ausführungsbeispiels näher erläutert. Es zeigen
- Figur 1 bis 2: einen Querschnitt durch ein Halbleitersubstrat, an dem die Schritte einer Ausführungsform des Verfahrens verdeutlicht werden, wobei der Schnitt entlang der in Fig. 3 angegebenen Linie I-I verläuft, und
- Figur 3: eine Aufsicht auf eine Ausführungsform der mit dem Verfahren hergestellten Halbleiterstruktur.

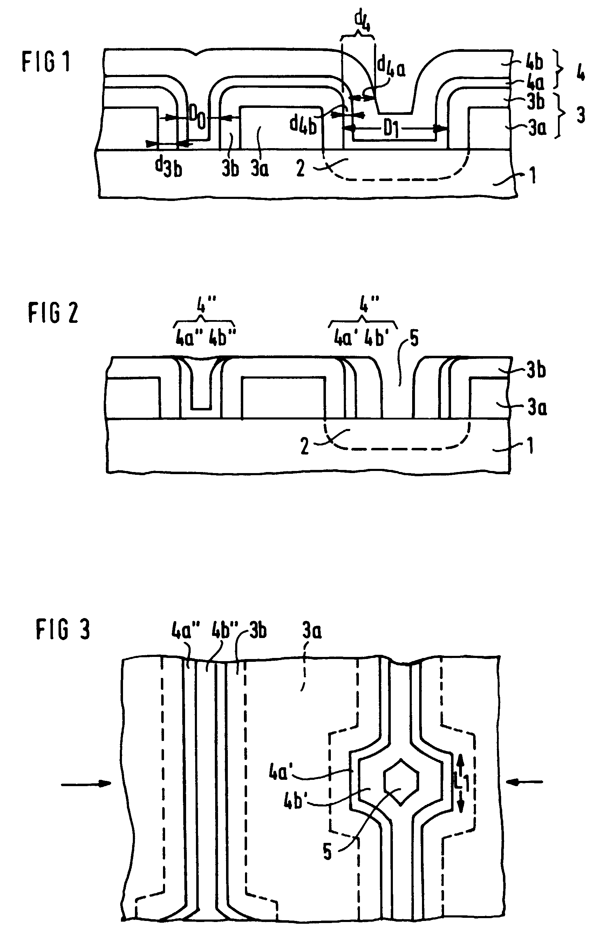

Figur 1: In einem Halbleitersubstrat befindet sich als zu kontaktierendes tieferliegendes leitendes Gebiet ein S/D-Gebiet 2 und als das Kontaktloch definierende bahnförmige Strukturen 3 Wortleitungen 3a mit einer Oxideinkapselung 3b an ihren Seiten und Oberflächen. Durch ein (nicht dargestelltes) Gateoxid sind die Wortleitungen 3a vom Halbleitersubstrat 1 isoliert. Zwischen benachbarten eingekapselten Wortleitungen 3 sind Zwischenräume, die über dem leitenden Gebiet 2 größer sind (Breite D₁) als über einem nicht zu kontaktierenden Teil des Halbleitersubstrats 1 (Breite D₀). Außerhalb dieser Aufweitungen D₁ ist der Zwischenraum vorzugsweise überall so gering wie prozeßtechnisch möglich, hier also bestimmt durch die Fototechnik zur Herstellung der Wortleitungen 3a und die zur Isolierung notwendige Schichtdicke der Oxideinkapselung 3b. In Richtung der Wortleitungen erstreckt sich die Aufweitung über eine Länge L₁, die vorzugsweise etwa dem Zwischenraum D₁ entspricht oder etwas kleiner ist. Der bevorzugte Wert für L₁ hängt unter anderem von der Ausdehnung des S/D-Gebietes 2 in Wortleitungsrichtung ab.

Nun wird ganzflächig eine isolierende Zwischenschicht 4 aufgebracht, die in diesem Ausführungsbeispiel eine Doppelschicht bestehend aus TEOS als unterer Teilschicht 4a und BPSG als oberer Teilschicht 4b ist. Die Dicke d₄ der Zwischenschicht 4 (gemessen an der Seitenwand der Oxideinkapselung) wird so gewählt, daß nur der schmale Zwischenraum D₀, nicht aber der aufgeweitete Zwischenraum D₁ vollständig aufgefüllt wird. Es ist also D₀/2 ≤ d₄ < D₁/2 und d₄ ≤ L₁/2 bei in etwa konformer Abscheidung derZwischenschicht 4 ist dies die nominell abzuscheidende Schichtdicke.

Figur 2: Anschließend wird die Zwischenschicht 4 ganzflächig anisotrop zurückgeätzt, bis das zu kontaktierende leitende Gebiet 2 mindestens teilweise freigelegt ist. In den schmalen Zwischenräumen verbleibt eine isolierende Auffüllung 4". Über den aufgeweiteten Zwischenräumen werden an den Seitenwänden der Oxideinkapselungen 3b isolierende Spacer 4' gebildet, die die freigeätzte Kontaktfläche zu dem S/D-Gebiet 2 umschließen. Die isolierenden Spacer 4' bilden also die Seitenwände des erzeugten selbstjustierten Kontaktlochs 5, sie bestehen in diesem Ausführungsbeispiel aus zwei nebeneinanderliegencden Teilspacern 4a', 4b'.

Erkennbar kann die seitliche Oxideinkapselung 3b der Wortleitung 3a auch weggelassen werden, soweit sie nicht (z. B. zur Herstellung sog. LDD-Transistoren) anderweitig benötigt wird, denn die Isolation zwischen Kontaktloch und Wortleitung wird ebensogut durch die Spacer 4 gewährleistet. In diesem Fall resultiert eine weitere Verringerung der Anzahl der Prozeßschritte, und die bahnförmigen Strukturen werden allein von den Wortleitungen 3a dargestellt.

Das Kontaktloch 5 ist offenbar selbstjustiert zu den Wortleitungen, nicht jedoch zu einem Feldoxid, das die S/D-Gebiete von in Wortleitungsrichtung benachbarten Transistoren voneinander trennt. Die Aufweitungen zwischen den Wortleitungen müssen daher in Wortleitungsrichtung auf das S/D-Gebiet ausreichend gut justiert sein, was jedoch im allgemeinen ohne Schwierigkeiten möglich ist, da das Kontaktloch durch die umgebenden Spacer sehr klein, z. B. kleiner als die lithografisch mögliche Minimaldimension hergestellt werden kann.

Die Abmessungen und Schichtdicken d können beispielsweise folgendermaßen gewählt werden:
d_{3b}= 0,2 µ
D₀= 0,4 µ
D₁= 1,0 µ
L₁= 0,6 µ
d₄ₐ= 100 nm
d_{4b}= 250 nm.

Die Ausmaße des Kontaktlochs betragen dann mindestens etwa 0,3 µ in Bitleitungsrichtung (d. h. senkrecht zu den Wortleitungen) und 0,4 µ in Wortleitungsrichtung.

Figur 3: Die Aufsicht auf das Halbleitersubstrat zeigt das selbstjustiert hergestellte Kontaktloch 5 umgeben von dem BPSG-Spacer 4b' sowie dem angrenzenden TEOS-Spacer 4a'. Die schmalen Zwischenräume D₀ sind vollständig mit der isolierenden Auffüllung 4" aufgefüllt. Unter der Oxideinkapselung 3b ist die Lage der Wortleitungen 3a gestrichelt angedeutet. Die Form der Kontaktfläche wird im wesentlichen durch die Form der Aufweitung bestimmt und kann beispielsweise etwa hexagonal sein. Durch die Auffüllung der Spalte ist die Oberfläche nun bereits ohne einen speziellen Planarisierungsprozeß (z. B. ein Verfließprozeß) relativ gut planarisiert.

In einer Weiterbildung des Verfahrens ist es möglich, gleichzeitig mit dem selbstjuistierten Kontaktloch 5 auch konventionelle, d. h. lithografisch definierte Kontaktlöcher herzustellen. Dies kann beispielsweise bei DRAM-Speichern vorteilhaft sein, wenn selbstjustierte Bitleitungskontakte im Zellenfeld und konventionelle Kontakte in der Peripherie erzeugt werden sollen. Es wird dann nach dem Aufbringen der Zwischenschicht 4 bzw. der BPSG-Schicht 4b eine Fotolackmaske erzeugt, die im Zellenfeld ganzflächig und in der Peripherie an den Stellen der Kontaktlöcher offen ist. Anschließend wird wie beschrieben isotrop geätzt, wobei im Zellenfeld die Zwischenschicht ganzflächig abgetragen wird. Mit einem Temperaturschritt kann ein Verfließen des BPSG erreicht werden.

Durch diese Vorgehensweise werden maßhaltige Kontaktlöcher in der Peripherie erzeugt, die durch das Verfließen nach der Ätzung gut verrundet sind. Ferner kann in der Peripherie eine gute Planarisierung dadurch erzielt werden, daß ein hochdotiertes BPSG mit entsprechend guten Verfließeigenschaften eingesetzt wird. Der Niveauunterschied zwischen Zellenfeld und Peripherie, der bei DRAM-Speichern z. B. durch die nur im Zellenfeld vorhandenen Speicherkondensatoren (stacked capacitor) entsteht und die weitere Prozessierung erschweren kann, wird beim erfindungsgemäßen Verfahren verringert, da die Zwischenschicht im Zellenfeld ganzflächig entfernt wird. Die Peripherie wird also relativ zum Zellenfeld um d₄ (zuzüglich einer eventuellen Überätzung) angehoben. Dies erleichtert die Strukturierung nachfolgender Ebenen.

## Patentansprüche

1. Herstellverfahren für ein selbstjustiertes Kontaktloch einer integrierten Halbleiterschaltung mit auf einem Halbleitersubstrat angeordneten bahnförmigen Strukturen (3), wobei das Kontaktloch (5) ein zwischen zwei bahnförmigen Strukturen befindliches, tieferliegendes leitendes Gebiet (2) mindestens teilweise freilegt,
mit folgenden Schritten:
- Herstellen der bahnförmigen Strukturen (3) derart, daß der Zwischenraum zwischen zwei bahnförmigen Strukturen über dem leitenden Gebiet (2) auf einer Länge L₁ eine größere Breite D₁ aufweist als über dem angrenzenden Halbleitersubstrat (1) mit der Breite D₀,
- Aufbringen einer Zwischenschicht (4) mit Schichtdicke d₄, wobei D₁/2 > d₄ ≥ D₀/2 und L₁/2 ≥ d₄,
- anisotropes Ätzen der Zwischenschicht (4), bis das leitende Gebiet (2) mindestens teilweise freigelegt ist.

2. Verfahren nach Anspruch 1, **dadurch gekennzeichnet**, daß als bahnförmige Strukturen (3) isoliert auf dem Halbleitersubstrat (1) aufgebrachte Wortleitungen (3a) mit einer Oxideinkapselung (3b) und als leitendes Gebiet (2) ein im Halbleitersubstrat (1) angeordnetes dotiertes Gebiet (2) verwendet werden.

3. Verfahren nach einem der Ansprüche 1 bis 2, **dadurch gekennzeichnet**, daß als Zwischenschicht (4) eine Doppelschicht bestehend aus einer unteren TEOS-Schicht (4a) und einer oberen hochdotierten BPSG-Schicht (4b) verwendet wird.

4. Verfahren nach einem der Ansprüche 1 bis 3, **dadurch gekennzeichnet**, daß nach dem anisotropen Ätzen ein Temperaturschritt durchgeführt wird.

5. Verfahren nach einem der Ansprüche 1 bis 4, **dadurch gekennzeichnet**, daß vor dem anisotropen Ätzen eine Fotolackmaske auf der Zwischenschicht (4) hergestellt wird, die ein erstes Gebiet aufweist, in welchem sie die Zwischenschicht (4) nicht bedeckt und in welchem die selbstjustierten Kontaktlöcher (5) hergestellt werden, und ein zweites Gebiet aufweist, in welchem sie die Zwischenschicht (4) im wesentlichen bedeckt und Kontakt löcher definiert, und daß das anisotrope Ätzen der Zwischenschicht unter Verwendung der Fotolackmaske durchgeführt wird, so daß gleichzeitig im ersten Gebiet selbstjustierte Kontaktlöcher und im zweiten Gebiet lithografisch definierte Kontaktlöcher hergestellt werden.

6. Halbleiterstruktur mit
- bahnförmigen Strukturen ( 3) mit freiliegender Oberfläche auf einem Halbleitersubstrat (1),
- einem zwischen den bahnförmigen Strukturen ( 3) angeordneten tieferliegenden leitenden Gebiet (2), wobei der Zwischenraum zwischen zwei bahnförmigen Strukturen über einem leitenden Gebiet eine größere Breite D₁ aufweist als über dem angrenzenden Halbleitersubstrat (1) mit der Breite D₀,
- einem Kontaktloch (5) in dem vergrößerten Zwischenraum (D₁), welches das leitende Gebiet (2) mindestens teilweise freilegt,
- einem isolierenden Spacer (4') zwischen dem Kontaktloch (5) und den Seitenwänden der bahnförmigen Strukturen (3) und
- einer isolierenden Auffüllung (4'') zwischen den Seitenwänden der benachbarten bahnförmigen Strukturen (3) mit dem Abstand D₀.

7. Halbleiterstruktur nach Anspruch 6,
**gekennzeichnet durch**
- isoliert auf dem Halbleitersubstrat (1) aufgebrachte Wortleitungen (3a) mit einer Oxideinkapselung (3b) als bahnförmige Strukturen (3) und
- ein im Halbleitersubstrat (1) angeordnetes dotiertes Gebiet (2) als leitendes Gebiet

8. Halbleiterstruktur nach Anspruch 6 oder 7,
**dadurch gekennzeichnet,** daß
- der isolierende Spacer (4') und die isolierende Auffüllung (4'') aus einer Doppelschicht, die eine TEOS-Schicht (4a) und eine BPSG-Schicht (4b) umfaßt, bestehen.

## Claims

1. Method for producing a self-aligned contact hole of an integrated semiconductor circuit having track structures (3) arranged on a semiconductor substrate, the contact hole (5) at least partially exposing a lower-lying, conductive region (2) situated between two track structures, having the following steps:
- production of the track structures (3) in such a way that the interspace between two track structures has a greater width D₁ above the conductive region (2) over a length L₁ than above the adjoining semiconductor substrate (1) having the width D₀,
- application of an intermediate layer (4) having a layer thickness d₄, where D₁/2 > d₄ ≥ D₀/2 and L₁/2 ≥ d₄,
- anisotropic etching of the intermediate layer (4) until the conductive region (2) is at least partially exposed.

2. Method according to Claim 1, characterized in that the track structures (3) used are word lines (3a), which are applied in an insulated manner to the semiconductor substrate (1) and have oxide encapsulation (3b), and the conductive region (2) used is a doped region (2) arranged in the semiconductor substrate (1).

3. Method according to either of Claims 1 and 2, characterized in that a double layer composed of a lower TEOS layer (4a) and an upper, highly doped BPSG layer (4b) is used as the intermediate layer (4).

4. Method according to one of Claims 1 to 3, characterized in that a temperature step is carried out after the anisotropic etching.

5. Method according to one of Claims 1 to 4, characterized in that, prior to the anisotropic etching, a photoresist mask is produced on the intermediate layer (4) and has a first region in which it does not cover the intermediate layer (4) and in which the self-aligned contact holes (5) are produced and has a second region in which it essentially covers the intermediate layer (4) and defines contact holes, and in that the anisotropic etching of the intermediate layer is carried out while using the photoresist mask, with the result that self-aligned contact holes are produced in the first region at the same time as lithographically defined contact holes are produced in the second region.

6. Semiconductor structure having
- track structures (3) having an exposed surface on a semiconductor substrate (1),
- a lower-lying, conductive region (2) arranged between the track structures (3), the interspace between two track structures having a greater width D₁ above a conductive region than above the adjoining semiconductor substrate (1) having the width D₀,
- a contact hole (5) in the enlarged interspace (D₁) which contact hole at least partially exposes the conductive region (2),
- an insulating spacer (4') between the contact hole (5) and the side walls of the track structures (3), and
- an insulating filling (4") between the side walls of the adjacent track structures (3) separated by the distance D₀.

7. Semiconductor structure according to Claim 6, characterized by
- word lines (3a), which are applied in an insulated manner to the semiconductor substrate (1) and have an oxide encapsulation (3b), as the track structures (3), and
- a doped region (2), which is arranged in the semiconductor substrate (1), as the conductive region.

8. Semiconductor structure according to Claim 6 or 7, characterized in that
- the insulating spacer (4') and the insulating filling (4") comprise of a double layer comprising a TEOS layer (4a) and a BPSG layer (4b).

## Revendications

1. Procédé de fabrication d'un trou de contact auto-ajusté d'un circuit intégré à semi-conducteur comportant des structures (3) en forme de piste disposées sur un substrat en semi-conducteur, le trou (5) de contact dégageant au moins partiellement une région (2) conductrice sous-jacente, se trouvant entre deux structures en forme de piste,
comportant les étapes suivantes :
- on fabrique les structures (3) en forme de piste de telle manière que l'intervalle entre deux structures en forme de piste comporte au-dessus de la région (2) conductrice sur une longueur (L₁), une largeur (D₁) plus grande qu'au-dessus du substrat (1) en semi-conducteur adjacent ayant la largeur (D₀),
- on dépose une couche (4) intermédiaire ayant une épaisseur (d₄) de couche, en ayant D₁/2 > d₄ ≥ D₀/2 et L₁/2 ≥ d₄,
- on attaque la couche (4) intermédiaire par attaque chimique anisotrope jusqu'à ce que la région (2) conductrice soit au moins partiellement dégagée.

2. Procédé suivant la revendication 1, caractérisé en ce que l'on utilise comme structure (3) en forme de piste des lignes (3a) de transmission de mots, déposées en étant isolées sur le substrat (1) en semi-conducteur et ayant une encapsulation (3b) d'oxyde, et comme région (2) conductrice, une région (2) dopée, disposée dans le substrat (1) en semi-conducteur.

3. Procédé suivant l'une des revendications 1 à 2, caractérisé en ce que l'on utilise comme couche (4) intermédiaire une double couche constituée d'une couche (4a) inférieure en TEOS et d'une couche (4b) à fort dopage en BPSG.

4. Procédé suivant l'une des revendications 1 à 3, caractérisé en ce que l'on effectue une étape de température après l'attaque chimique anisotrope.

5. Procédé suivant l'une des revendications 1 à 4, caractérisé en ce que, avant l'attaque chimique anisotrope, on produit sur la couche (4) intermédiaire un masque de vernis photosensible qui comporte une première région dans laquelle il ne recouvre pas la couche (4) intermédiaire et dans laquelle les trous (5) de contact auto-ajustés sont produits, et une deuxième région dans laquelle il couvre sensiblement la couche (4) intermédiaire et définit des trous de contact, et en ce que l'attaque chimique anisotrope de la couche intermédiaire est effectuée en utilisant le masque de vernis photosensible, si bien qu'il est produit en même temps dans la première région des trous de contact autoajustés et dans la deuxième région, des trous de contact définis par lithographie.

6. Structure à semi-conducteur comportant
- des structures (3) en forme de piste à surface dégagée sur un substrat (1) en semi-conducteur,
- une région (2) conductrice sous-jacente, disposée entre les structures (3) en forme de piste, l'intervalle entre deux structures en forme de piste ayant au-dessus d'une région conductrice une largeur (D₁) plus grande qu'au-dessus du substrat (1) en semi-conducteur adjacent ayant la largeur (D₀),
- un trou (5) de contact dans l'intervalle (D₁) agrandi, qui dégage au moins partiellement la région (2) conductrice,
- une couche (4') d'écartement isolante entre le trou (5) de contact et les parois latérales des structures (3) en forme de piste et
- un remplissage (4") isolant entre les parois latérales des structures (3) voisines en forme de piste, ayant la distance (D₀).

7. Substrat à semi-conducteur suivant la revendication 6, caractérisé par
- des lignes (3a) de transmission de mots, déposées en étant isolées sur le substrat (1) en semi-conducteur et comportant une encapsulation (3b) d'oxyde, comme structure (3) en forme de piste et
- une région (2) dopée, disposée dans le substrat (1) en semi-conducteur, comme couche conductrice.

8. Structure à semi-conducteur suivant la revendication 6 ou 7, caractérisée en ce que
- la couche (4') d'espacement isolante et le remplissage (4") isolant sont constitués d'une double couche qui comprend une couche (4a) en TEOS et une couche (4b) en BPSG.
